# EUROPEAN PATENT SPECIFICATION

(11) **EP 2 383 795 B1**
(45) Date of publication and mention of the grant of the patent: **02.07.2014**
(21) Application number: 10735853.3
(22) Date of filing: 28.01.2010
(51) Int. Cl.: H01L 31/04, H01L 27/142

(54) **PHOTOELECTRIC CONVERSION CELL AND PHOTOELECTRIC CONVERSION MODULE**
ZELLE FÜR PHOTOELEKTRISCHE UMWANDLUNG UND MODUL FÜR PHOTOELEKTRISCHE UMWANDLUNG
CELLULE DE CONVERSION PHOTOÉLECTRIQUE ET MODULE DE CONVERSION PHOTOÉLECTRIQUE

(30) Priority: 29.01.2009 JP 2009018411
(43) Date of publication of application: 02.11.2011
(73) Proprietor: Kyocera Corporation, Kyoto-shi Kyoto 612-8501 (JP)
(72) Inventor: HATATE, Atsuo, Higashiomi-shi Shiga 527-8555 (JP); ARIMUNE, Hisao, Higashiomi-shi Shiga 527-8555 (JP)
(74) Representative: Witte, Weller & Partner Patentanwälte mbB
(86) International application number: PCT/JP2010/051095
(87) International publication number: WO 2010/087388

(56) References cited:
- JP-A- 2000 299 486
- JP-A- 2002 373 995
- JP-A- 2008 159 917
- US-A1- 2008 314 439

## Description

### Technical Field

The present invention relates to a photoelectric conversion cell for generating electric power by light absorption, and a photoelectric conversion module with a plurality of the photoelectric conversion cells.

### Background Art

In a known photoelectric conversion module such as a solar cell, a constituent unit is a photoelectric conversion cell with a linear collector electrode formed on a light receiving surface, and a plurality of the photoelectric conversion cells are connected in series on a substrate made of glass and the like. In the solar cell disclosed in Japanese Patent Application Laid-Open No. 2002-373995, a plurality of collector electrodes and auxiliary electrodes crossing the collector electrodes are provided on a light receiving surface. These collector electrodes and auxiliary electrodes are formed by collectively printing a metal paste into a desired pattern by screen printing.

However, the structure of the solar cell of the Japanese Patens Application Laid-Open No. 2002-373995 raises temperature as a result of irradiation with sunlight and the like. Thus, stress is generated in the auxiliary electrodes made of the metal paste, causing the auxiliary electrodes to fall off easily. This reduces electrical connection reliability, so photoelectric conversion efficiency is likely to decrease. Document US2008/314439 A discloses integrated solar cells.

Thus, a photoelectric conversion cell and a photoelectric conversion module exhibiting excellence in connection reliability, and which are capable of maintaining photoelectric conversion efficiency at a high level have been desired.

### Summary of Invention

A photoelectric conversion cell according to one aspect of the present invention includes: first and second electrode layers spaced apart from each other; a first semiconductor layer of a first conductivity type provided on the first electrode layer; a second semiconductor layer of a second conductivity type provided on the first semiconductor layer, the second semiconductor layer forming a pn junction with the first semiconductor layer; a connecting portion for electrically connecting the second semiconductor layer and the second electrode layer; and a plurality of collector electrodes each with a linear portion and a projecting portion, the linear portion extending on the second semiconductor layer from a position above the connecting portion toward an end of the second semiconductor layer, the projecting portion overlapping at least partially the connecting portion in top perspective view, while projecting from at least one of opposite ends of the linear portion in its shorter side direction. In two adjacent ones of the plurality of collector electrodes, the projecting portions of the adjacent collector electrodes are spaced apart from each other.

A photoelectric conversion module includes a plurality of the photoelectric conversion cells as recited above. The plurality of photoelectric conversion cells include first and second photoelectric conversion cells. In the first and second photoelectric conversion cells, respective ones of the first and second electrode layers face in the same direction, and the second electrode layer of the first photoelectric conversion cell and the first electrode layer of the second photoelectric conversion cell are electrically connected.

### Brief Description of Drawings

Fig. 1 is a perspective view of a photoelectric conversion cell and a photoelectric conversion module of a first embodiment according to the present invention;
Fig. 2 is a sectional view of the photoelectric conversion cell and the photoelectric conversion module shown in Fig. 1;
Fig. 3 is a plan view of the photoelectric conversion cell and the photoelectric conversion module shown in Fig. 1;
Figs. 4A to 4E includes sectional views showing corresponding steps of a method of manufacturing the photoelectric conversion cell and the photoelectric conversion module shown in Fig. 1;
Fig. 5 is a perspective view of a photoelectric conversion cell and a photoelectric conversion module of a second embodiment according to the present invention;
Fig. 6 is a sectional view of the photoelectric conversion cell and the photoelectric conversion module shown in Fig. 5;
Figs. 7A to 7E includes sectional views showing corresponding steps of a method of manufacturing the photoelectric conversion cell and the photoelectric conversion module shown in Fig. 5;
Fig. 8 is a perspective view of a photoelectric conversion cell and a photoelectric conversion module of a third embodiment according to the present invention; and
Fig. 9 is a plan view of the photoelectric conversion cell and the photoelectric conversion module shown in Fig. 8.

### Mode(s) for Carrying Out the Invention

Embodiments of the present invention are described in detail below by referring to the drawings.

A photoelectric conversion cell and a photoelectric conversion module of a first embodiment according to the present invention are described first.

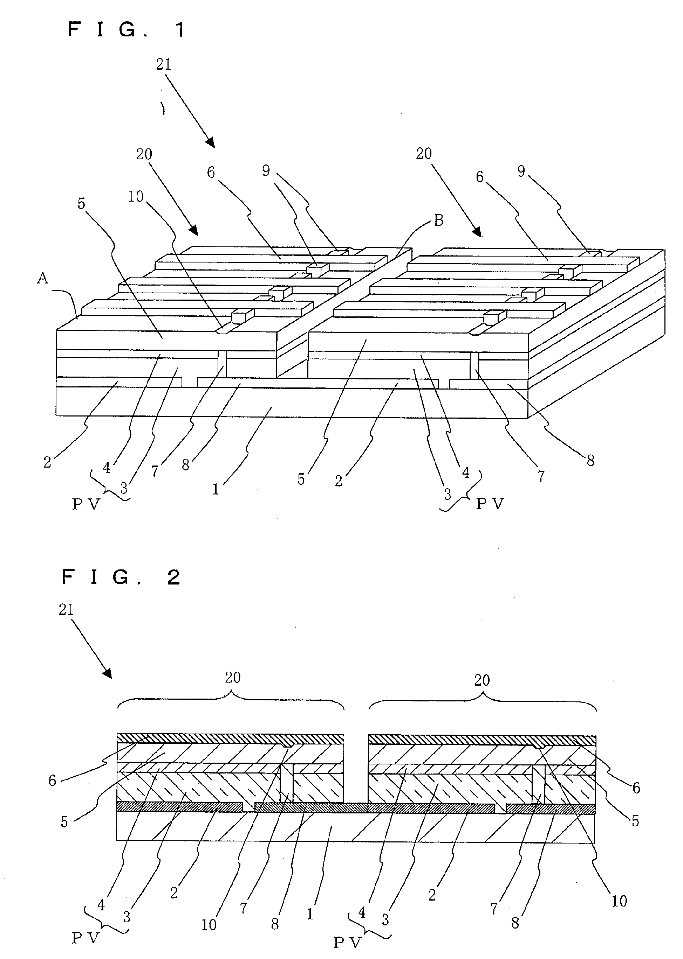

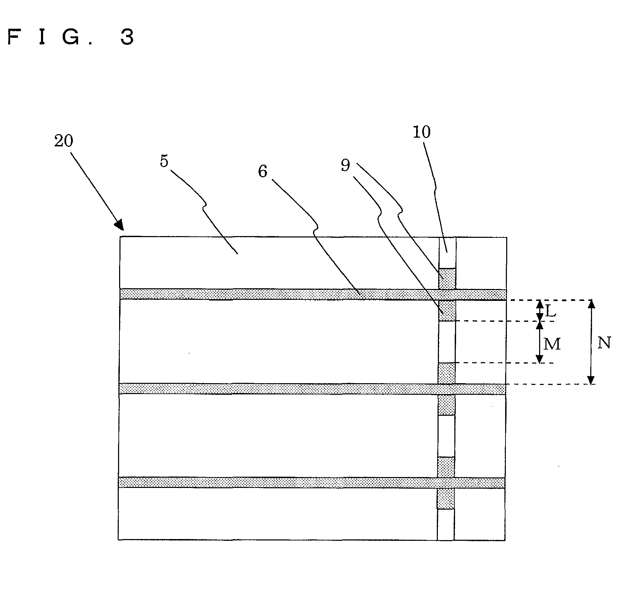

Fig. 1 shows the structures of a photoelectric conversion cell 20, and a photoelectric conversion module 21 using the photoelectric conversion cell 20 according to the first embodiment of the present invention. Figs. 2 and 3 are sectional and plan views respectively of the photoelectric conversion cell 20 and the photoelectric conversion module 21. The photoelectric conversion cell 20 includes a substrate 1, first and second electrode layers 2 and 8, first and second semiconductor layers 3 and 4, a conductive layer 5, linear portions 6 of collector electrodes, projecting portions 9 of the collector electrodes, and a connecting portion 7. The first and second semiconductor layers 3 and 4 form a photoelectric conversion layer PV. The linear portions 6 and the projecting portions 9 form the collector electrodes.

The photoelectric conversion module 21 includes a plurality of lined up photoelectric conversion cells 20. The second electrode layer 8 of one of adjacent photoelectric conversion cells 20 is electrically connected to the first electrode layer 2 of the other one of the adjacent photoelectric conversion cells 20. This structure easily makes series connection between the adjacent photoelectric conversion cells 20. In one photoelectric conversion cell 20, the connecting portion 7 is provided to divide the photoelectric conversion layer PV. This means that, in Fig. 1, the connecting portion 7 extends in a line shape from the front side surface toward the opposite back side surface of the photoelectric conversion cell 20. Photoelectric conversion is performed in the photoelectric conversion layer PV on the left side of the connecting portion 7 and defined between the first electrode layer 2 and the conductive layer 5.

The substrate 1 supports the photoelectric conversion cells 20. Examples of the material of the substrate 1 include glass, ceramics, resin, and metal. In order to form the photoelectric conversion module 21, two or more substrates 1 on which the corresponding photoelectric conversion cells 20 are provided may be arranged in series. Or, a plurality of photoelectric conversion cells 20 may be provided on one substrate 1. Providing a plurality of photoelectric conversion cells 20 on one substrate 1 makes the formation of the photoelectric conversion module 21 easy.

The first and second electrode layers 2 and 8 are made of a conductive material such as Mo, Al, Ti, and Au, and are formed by sputtering or vapor deposition on the substrate 1. In the adjacent photoelectric conversion cells 20 shown in Fig. 1, the second electrode layer 8 of one of the photoelectric conversion cells 20 and the first electrode layer 2 of the other one of the photoelectric conversion cells 20 are united.

The photoelectric conversion layer PV includes the first and second semiconductor layers 3 and 4. The photoelectric conversion layer PV is capable of absorbing light and converting the absorbed light to electric power, and is made of a semiconductor material such as a silicon based semiconductor material and a compound semiconductor. Examples of the silicon based semiconductor material include single-crystalline silicon, polycrystalline silicon, and amorphous silicon. Examples of the compound semiconductor include single-crystalline compound semiconductors and polycrystalline semiconductors such as III-V compound semiconductors, II-VI compound semiconductors, and chalcopyrite (also called CIS) compound semiconductors.

The photoelectric conversion layer PV using the chalcopyrite compound semiconductor, that is one of the thin-film photoelectric conversion layers PV listed above, exhibits high conversion efficiency. So, this photoelectric conversion layer PV achieves photoelectric conversion efficiency despite its thinness that is substantially the same as that of conventional single-crystalline silicon, and is especially preferable accordingly. The chalcopyrite compound semiconductor is also preferable as it does not contain harmful cadmium. Examples of the chalcopyrite compound semiconductor include Cu (In, Ga) Se₂ (also called CIGS), Cu (In, Ga) (Se, S)₂ (also called CIGSS), and CuInS₂ (also called CIS). The photoelectric conversion layer PV is formed for example by sputtering, vapor deposition and coating if formed into a thin film. Cu (In, Ga) Se₂ is a compound consisting mainly of Cu, In, Ga, and Se. Cu (In, Ga) (Se, S)₂ is a compound consisting mainly of Cu, In, Ga, Se, and S.

The first and second semiconductor layers 3 and 4 have different conductivity types; one is n-type and the other is p-type that form a pn junction. The first semiconductor layer 3 may be of the p-type and the second semiconductor layer 4 may be of the n-type. Or, the relationship may be reversed. The pn junction between the first and second semiconductor layers 3 and 4 is not necessary formed by direct junction between the first and second semiconductor layers 3 and 4. As an example, a different semiconductor layer of the same conductivity type as the first or second semiconductor layer 3 or 4 may be placed between the first and second semiconductor layers 3 and 4. Or, an i-type semiconductor layer may be placed between the first and second semiconductor layers 3 and 4 to form a pin junction.

The first and second semiconductor layers 3 and 4 may be connected to form a homo junction or a hetero junction. In order to form the hetero junction, if the first semiconductor layer 3 is a chalcopyrite compound semiconductor such as CIGS (what is generally called a light absorption layer), examples of the second semiconductor layer 4 include CdS, ZnS, ZnO, In₂Se₃, In (OH, S), (Zn, In) (Se, OH), and (Zn, Mg) O (what is generally called a buffer layer). In this case, the first and second semiconductor layers 3 and 4 are formed for example by chemical bath deposition (CBD). In (OH, S) is a compound consisting mainly of In, OH, and S. (Zn, In) (Se, OH) is a compound consisting mainly of Zn, In, Se, and OH. (Zn, Mg) O is a compound consisting mainly of Zn, Mg, and O.

The conductive layer 5 may be provided on the second semiconductor layer 4 as shown in Fig. 1, so that charges generated in the photoelectric conversion layer PV can be extracted well, thereby enhancing power generation efficiency more. The conductive layer 5 is made of a conductive material such as ITO or ZnO: Al, and is formed by sputtering, vapor deposition, chemical vapor deposition (CVD), or the like. The conductive layer 5 enhances absorption efficiency of the photoelectric conversion layer PV if used as a light receiving surface. So, the conductive layer 5 preferably has a light transmission property for light absorbed by the photoelectric conversion layer PV. The conductive layer 5 has a thickness that is preferably from 0.05 to 0.5 µm in order to enhance the light transmission property and to transfer current generated as a result of photoelectric conversion well to the collector electrodes.

A plurality of photoelectric conversion cells 20 may be lined up, and these photoelectric conversion cells 20 may be electrically connected to form the photoelectric conversion module 21. In order to easily form series connection between adjacent photoelectric conversion cells 20, the second semiconductor layer 4 and the second electrode layer 8 are electrically connected by the connecting portion 7 in the photoelectric conversion cell 20 as shown in Figs. 1 and 2. In Fig. 1, the conductivity of the electrical connection between the second semiconductor layer 4 and the second electrode layer 8 is enhanced by the provision of the conductive layer 5, to which the structure is not limited. The structure may also be such that it does not include the conductive layer 5.

Preferably, the connecting portion 7 is formed together with the conductive layer 5, and is integrated with the conductive layer 5. In other words, the conductive layer 5 has an extending portion that extends from the second semiconductor layer 4 toward the second electrode layer 8, and the extending portion is connected to the second electrode layer 8. This means that the conductive layer 5 constitutes the connecting portion 7, so that process steps are simplified and electrical connection reliability is enhanced.

One of ends of the photoelectric conversion layer PV may be defined as a first end A, and the other end thereof opposite the first end A may be defined as a second end B. If the linear portions 6 of the collector electrodes extend from the first end A toward the second end B, the connecting portion 7 is preferably nearer the second end B than the first end A of the photoelectric conversion layer PV in plan view, namely is preferably near the second end B. More preferably, in plan view, the connecting portion 7 extends linearly in a direction substantially parallel to the second end B of the photoelectric conversion layer PV. This structure makes the connecting portion 7 get nearer the second end B to reduce an area between the connecting portion 7 and the second end B that becomes a dead space making no contribution to power generation, thereby enhancing photoelectric conversion efficiency.

The linear portions 6 of the collector electrodes are formed on the second semiconductor layer 4, and are intended to reduce electrical resistance in order to extract charges well generated in the second semiconductor layer 4. The linear portions 6 are arranged like railway tracks in order to suppress shield of light to be transmitted to the photoelectric conversion layer PV. Preferably, the linear portions 6 arranged like railway tracks extend to reach the first end A of the second semiconductor layer 4, namely to reach the first end A of the photoelectric conversion layer PV in plan view. This structure makes the linear portions 6 protect the outer periphery of the photoelectric conversion layer PV. Thus, generation of a chip at the outer periphery of the photoelectric conversion layer PV is suppressed, so that photoelectric conversion is performed well even at the outer periphery of the photoelectric conversion layer PV. Further, current generated at the outer periphery of the photoelectric conversion layer PV can be taken out efficiently by the linear portions 6 extending to the first end A, so that power generation efficiency is enhanced.

As described, the linear portions 6 extending to the first end A can protect the outer periphery of the photoelectric conversion layer PV, so that the total thickness of the members placed between the first electrode layer 2 and the linear portions 6 can be reduced. This allows reduction of the members and shortening of a time required to prepare the members. The total thickness of the members placed between the first electrode layer 2 and the linear portions 6 (in the example of Figs. 1 and 2, the total thickness of the first and second semiconductor layers 3 and 4, and the conductive layer 5) is preferably made smaller to a range of from 1.56 to 2.7 µm. Specifically, in the example of Figs. 1 and 2, the thicknesses of the first and second semiconductor layers 3 and 4, and of the conductive layer 5 may be set to range from 1.5 to 2.0 µm, from 0.01 to 0.2 µm, and from 0.05 to 0.5 µm respectively.

It is also preferable that end sections of the linear portions 6, of the conductive layer 5, and of the photoelectric conversion layer PV are on the same plane, preferably at the first end A of the photoelectric conversion layer PV to which the linear portions 6 extend. This produces a result that current generated at the first end A of the photoelectric conversion layer PV as a result of photoelectric conversion can be taken out well.

The extension of the linear portions 6 to the first end A of the photoelectric conversion layer PV preferably means that the linear portions 6 extend as far as to the outermost first end A of the photoelectric conversion layer PV completely, to which the present invention is not limited. More specifically, in order to effectively suppress development of a crack from the first end A of the photoelectric conversion layer PV to suppress generation of a chip, the outermost first end A of the photoelectric conversion layer PV and ends of the linear portions 6 may be spaced by a distance of 1000 µm or less. In order for the linear portions 6 to collect power more efficiently at the first end A, a distance between the first end A and the ends of the linear portions 6 is preferably 500 µm or less.

In order to suppress shield of light to be transmitted to the photoelectric conversion layer PV and to suppress generation of a chip at the outer periphery of the photoelectric conversion layer PV, the linear portions 6 preferably have a width of 50 to 400 µm. The linear portions 6 may have a plurality of separate branches.

In upper perspective view, the projecting portions 9 of the collector electrodes overlap the connecting portion 7, and project from at least one of opposite ends of the linear portions 6 in its shorter side direction. In Fig. 1, the projecting portions 9 overlap the connecting portion 7 and project from the linear portions 6 in the direction in which the connecting portion 7 extends like a line. The projecting portions 9 are provided to reduce resistance of electrical connection between the linear portions 6 and the second electrode layer 8 to enhance conductivity.

The projecting portions 9 of adjacent collector electrodes are separated. More specifically, a tip end of the projecting portion 9 of one of the collector electrodes is an open end that is not connected to both the linear portion 6 and the projecting portion 9 of the other one of the collector electrodes. Thus, the projecting portions 9 do not extend continuously like a line, but they are broken between adjacent collector electrodes. So, according to this structure, stress generated in the projecting portions 9 is relaxed at the broken part, so that the projecting portions 9 are prevented from falling off even if the photoelectric conversion cells 20 are placed under high temperature during use. As a result, electrical connection reliability is enhanced to maintain photoelectric conversion efficiency at a high level. The provision of the projecting portions 9 realizes favorable conduction between the linear portions 6 and the second electrode layer 8. This also enhances photoelectric conversion efficiency.

The aforementioned projecting portions 9 enhance manufacturing yield when the linear portions 6 and the projecting portions 9 are formed by screen printing with a metal paste. The reason therefor is as follows. Screen printing is a process where a screen is rubbed with a metal paste with a rubber spatula that is what is called a squeegee to print the metal paste. Openings of a desired pattern at which the metal paste is squeezed out are defined on the screen. The squeegee may collide with the edge portions of the openings when the squeegee moves from the openings to the screen, thereby damaging the screen easily. In the conventional structure such as that disclosed in Japanese_Patent Application Laid-Open No. 2002-373995, long linear auxiliary electrodes that continuously extend are arranged to cross a plurality of linear portions. When the squeegee is caused to move in this structure, the squeegee gives an impact across the edge portions of the openings on the screen for forming the auxiliary electrodes, thereby damaging the screen easily. Thus, the structure of Japanese Patent Application Laid-Open No. 2002-373995 fails to perform accurate screen printing, thereby reducing manufacturing yield. In contrast, the aforementioned projecting portions 9 of the photoelectric conversion cell 20 effectively lessens the impact of the squeegee to be applied to the edge portions of the openings on the screen for forming the projecting portions 9 even when the squeegee is caused to move. This suppresses a damage of the squeegee to enhance manufacturing yield.

At this time, by making the direction in which the linear portions 6 extend like railway tracks parallel to the printing direction of screen printing, the linear portions 6 are allowed to have a linewidth that is made small stably. This makes light shield by the linear portions 6 less likely, so that photoelectric conversion efficiency is enhanced. That is, the squeegee preferably moves in a direction substantially the same as the direction in which the linear portions 6 extend like railway tracks.

As shown in Figs. 1 and 3, the projecting portions 9 preferably extend from the opposite sides of the linear portion 6 to be substantially line symmetric with respect to the linear portion 6. This realizes effective conduction between the linear portions 6 and the second electrode layer 8.

As shown in Figs. 1 to 3, the connecting portion 7 preferably has a recess 10 defined above its upper surface. More specifically, in Fig. 1, the main surface of the conductive layer 5 is recessed to form a trench along the connecting portion 7. The projecting portions 9 are provided to get into the recess 10 in the form of a trench. This structure increases a contact area between the projecting portions 9 and the conductive layer 5, so that the projecting portions 9 are more effectively prevented from falling off, thereby enhancing electrical connection reliability to a greater extent. This structure also causes the metal paste to spread to get under the screen at the recess 10 during screen printing, so that the metal paste can extend long along the recess 10, compared to that defined in the openings of the screen. As a result, openings of the screen corresponding to the projecting portions 9 can be reduced to some extent, so that the impact of the squeegee on the edge portions of the openings of the screen is lessened to a lower level.

In order to allow the metal paste to get under the screen well during screen printing, and to form a desired pattern favorably, the depth of the recess 10 is preferably from 1% to 10% of the width of the recess 10 (from 1 µm to 10 µm if the width of the recess 10 is 100 µm, for example).

The recess 10 may be formed during simultaneous formation of the conductive layer 5 and the connecting portion 7 by a thin film forming technique. In this case, for forming the recess 10, a condition of thin film formation may be controlled to finish the formation of the conductive layer 5 with a surface of the conductive layer 5 recessed. Or, the recess 10 may be formed by removing a surface of the conductive layer 5 by etching and the like. The bottom part of the recess 10 is preferably deeper than the upper surface of the photoelectric conversion layer PV. In this case, the projecting portions 9 getting into the recess 10 get nearer the second electrode layer 8. This reduces electrical resistance, so that current generated as a result of photoelectric conversion can be taken out well.

In order to achieve favorable conduction between the linear portions 6 and the second electrode layer 8, a length L of the projecting portion 9 defined in a direction along the connecting portion 7 is preferably 5 µm or more, and more preferably, 400 µm or more. In order to prevent the projecting portions 9 from falling off by relaxing stress, a distance M between the opposite projecting portions 9 is preferably 50 µm or more. In Fig. 3, the projecting portions 9 extend from the opposite sides of each of the adjacent linear portions 6, and tip ends of the projecting portions 9 of the adjacent linear portions 6 are opposite each other between the linear portions 6. Meanwhile, if the projecting portion 9 extends only from one of opposite ends of the linear portion 6 in its shorter side direction, the aforementioned distance M means a distance between the tip end of the projecting portion 9 and the adjacent linear portion 6.

The length L is preferably from 0.15 to 0.40 times a distance N between the linear portions 6. This structure provides favorable electrical connection between the linear portions 6 and the second electrode layer 8, maintains favorable printing performance, and lessens the impact of the squeegee. Specifically, the distance N is preferably from 1.5 to 2.5 mm, and the length L is preferably from 225 to 1000 µm.

As an example, the linear portions 6 and the projecting portions 9 may be formed by printing a paste of metal such as Ag (mixture of metal particles and resin), and by curing the metal paste. That is, the linear portions 6 preferably contain metal particles and resin, as this enhances tolerance to bending stress of the linear portions 6 after curing.

The linear portions 6 and the projecting portions 9 preferably contain solder, as this increases tolerance to bending stress and reduces resistance further. More preferably, the linear portions 6 and the projecting portions 9 contain metals of two types or more of different melting points. In this case, the linear portions 6 and the projecting portions 9 are preferably heated and cured at a temperature at which at least one of these metals melts, and at least one of the remaining metals does not melt. Thus, the metal of a lower melting point is caused to melt to thereby densify the linear portions 6 and the projecting portions 9. As a result, resistance is reduced, and spread of the melted metal during heating and curing is prevented with the metal of a higher melting point.

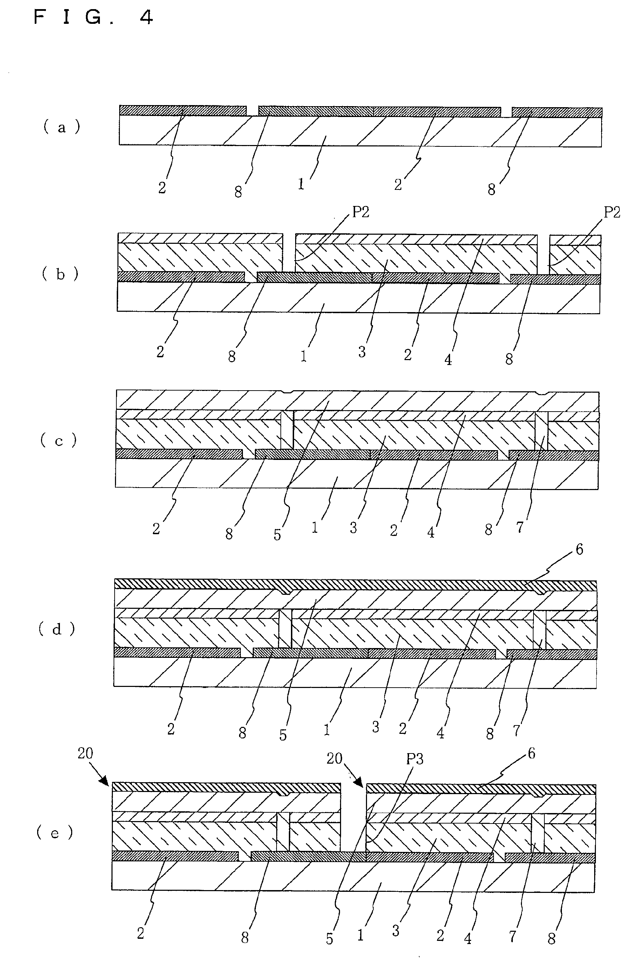

The photoelectric conversion cell 20 may be manufactured as follows. Figs. 4A to 4E are sectional views showing corresponding steps of manufacturing the photoelectric conversion cell 20.

First, as shown in Fig. 4A, the first and second electrode layers 2 and 8 of desired patterns are formed on the substrate 1. The patterned first and second electrode layers 2 and 8 may be formed by a thin film forming technique such as sputtering, or by a pattern forming technique such as scribing and etching.

Next, as shown in Fig. 4B, the first and second semiconductor layers 3 and 4 are stacked on the substrate 1, and the first and second electrode layers 2 and 8 by a thin film forming technique such as sputtering and CBD. Then, penetrating trenches P2 for defining the connecting portions 7 are formed by a technique such as scribing and etching.

As shown in Fig. 4C, the conductive layer 5 is thereafter formed on the second semiconductor layer 4, and at the same time, extending portions to function as the connecting portions 7 are formed in the penetrating trenches P2. The conductive layer 5 and the connecting portions 7 may be formed by a thin film forming technique such as sputtering.

Then, as shown in Fig. 4D, a metal paste is printed into a pattern on the conductive layer 5 by a technique such as screen printing. The printed metal paste is heated and then cured, thereby forming the linear portions 6 and the projecting portions 9.

In a final step, as shown in Fig. 4E, with the second electrode layer 8 left unremoved, the first and second semiconductor layers 3 and 4, the conductive layer 5, and the linear portions 6 are collectively cut out by a technique such as scribing. As a result of this process, the photoelectric conversion cells 20 are easily formed in each one of which the linear portions 6 extend to the first end A of the photoelectric conversion layer PV in plan view. In the adjacent photoelectric conversion cells 20, the first electrode 2 of one of the photoelectric conversion cells 20 and the second electrode layer 8 of the other one of the photoelectric conversion cells 20 are united. This makes series connection between the adjacent photoelectric conversion cells 20, so that the photoelectric conversion module 21 with the plurality of photoelectric conversion cells 20 connected in series is easily formed.

A photoelectric conversion cell and a photoelectric conversion module of a second embodiment of the present invention are described below.

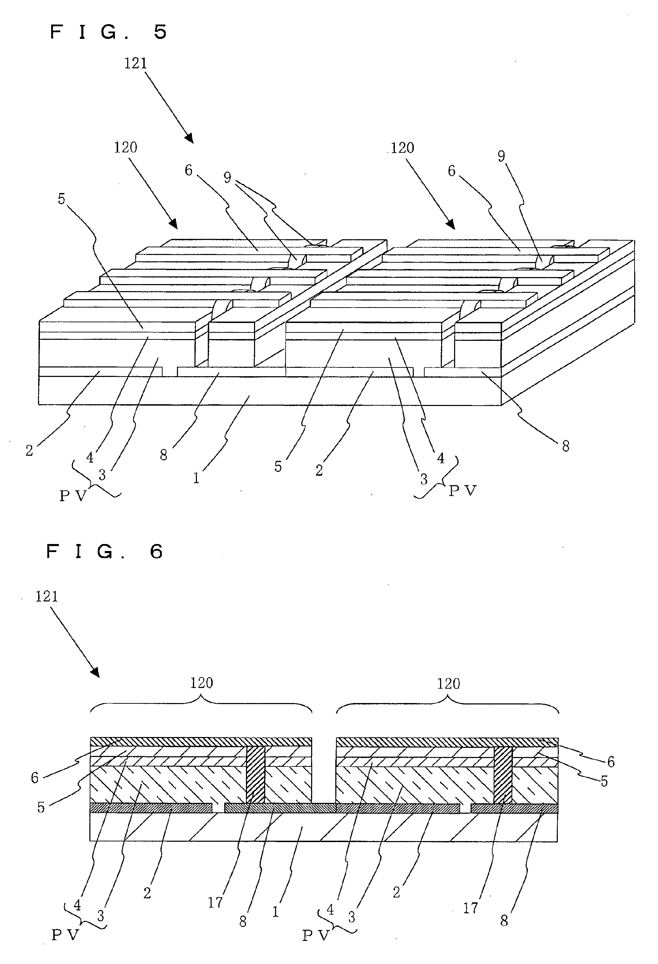

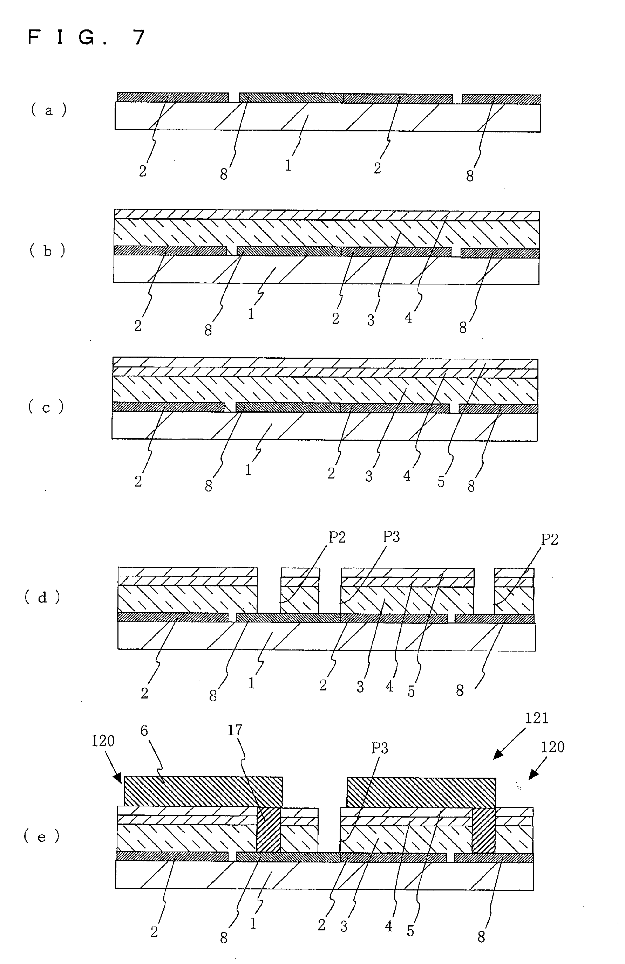

Fig. 5 shows the structures of a photoelectric conversion cell 120 and a photoelectric conversion module 121 of the second embodiment of the present invention. Fig. 6 is a sectional view of the photoelectric conversion cell 120 and the photoelectric conversion module 121. Figs. 7A to 7E include sectional views showing corresponding steps of manufacturing the photoelectric conversion cell 120 and the photoelectric conversion module 121. In Figs. 5 to 7E, the same constituent elements as those of the photoelectric conversion cell 20 and the photoelectric conversion module 21 of the first embodiment shown in Figs. 1 to 4E are designated by the same reference numerals, and can be of the same structures as those of the corresponding constituent elements.

The photoelectric conversion cell 120 and the photoelectric conversion module 121 of the second embodiment are different from the photoelectric conversion cell 20 and the photoelectric conversion module 21 of the first embodiment in that, the projecting portions 9 extend toward the second electrode layer 8 to be connected to the second electrode layer 8, so that connecting portions 17 are constructed of the projecting portions 9. The connection of the projecting portions 9 to the second electrode layer 8 to form the connecting portions 17 achieves more reliable connection, thereby enhancing connection reliability.

The photoelectric conversion cell 120 and the photoelectric conversion module 121 are formed as follows. First, as shown in Fig. 7A, the first and second electrode layers 2 and 8 of desired patterns are formed on the substrate 1. Next, as shown in Fig. 7B, the first and second semiconductor layers 3 and 4 are stacked on the substrate 1, and the first and second electrode layers 2 and 8. Then, as shown in Fig. 7C, the conductive layer 5 is formed on the second semiconductor layer 4. Next, as shown in Fig. 7D, the penetrating trenches P2 for defining the connecting portions 17, and a penetrating trench P3 for defining a space between the photoelectric conversion cells 120, are formed by a technique such as scribing and etching. In a final step, as shown in Fig. 7E, a metal paste is printed into a pattern on the conductive layer 5 and inside part of the penetrating trenches P2 by a technique such as screen printing. The printed metal paste is heated and then cured, thereby forming the linear portions 6 and the projecting portions 9. As a result, the photoelectric conversion devices 120 each with the connecting portions 17, and the photoelectric conversion module 121 are completed.

As described, the first and second semiconductor layers 3 and 4, and the conductive layer 5 are successively formed. Then, the penetrating trenches P2 for defining the connecting portions 17, and the penetrating trench P3 for defining a space between the photoelectric conversion cells 120, are formed at the same time. This simplifies a step of trench process, thereby enhancing productivity.

A photoelectric conversion cell and a photoelectric conversion module of a third embodiment of the present invention are described next.

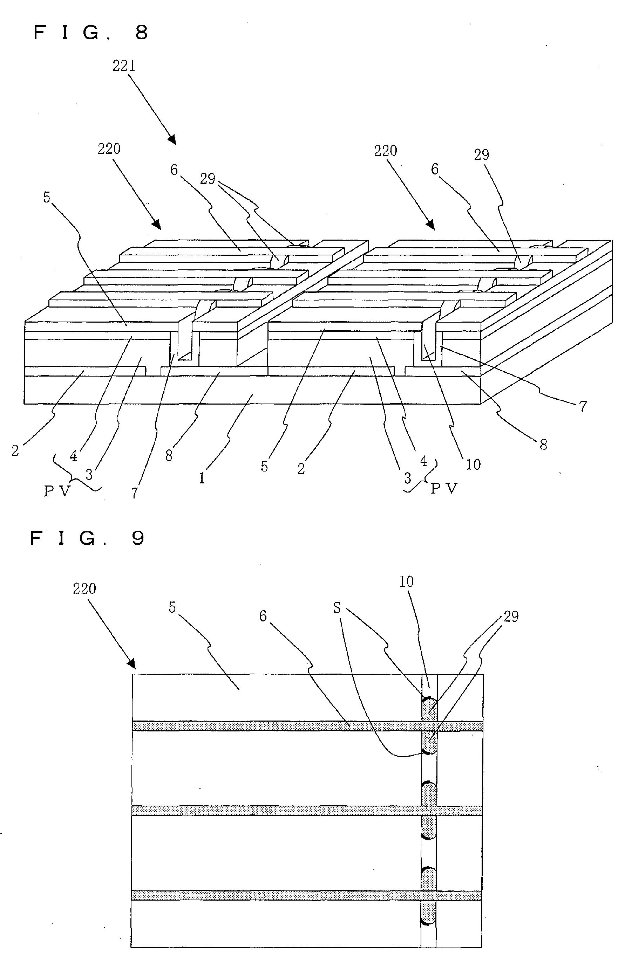

Fig. 8 shows the structures of a photoelectric conversion cell 220 and a photoelectric conversion module 221 of the third embodiment of the present invention. Fig. 9 is a plan view of the photoelectric conversion cell 220 and the photoelectric conversion module 221. In Figs. 8 and 9, the same constituent elements as those of the photoelectric conversion cell 20 and the photoelectric conversion module 21 of the first embodiment shown in Figs. 1 to 4E are designated by the same reference numerals, and can be of the same structures as those of the corresponding constituent elements.

In the photoelectric conversion cell 220 and the photoelectric conversion module 221 of the third embodiment, the recess 10 of the connecting portion 7 is formed to reach a level deeper than the upper main surface of the second semiconductor layer 4. Projecting portions 29 are provided to get into the recess 10, and front end surfaces S of the projecting portions 29 (the front end surfaces S are shown by bold lines in Fig. 9) are opposite at least either a side surface of the first semiconductor layer 3 or a side surface of the second semiconductor layer 4 while being tilted relative to either the side surface. According to this structure, incoming light is allowed to enter the photoelectric conversion layer PV through its side surface after being reflected off the front end surfaces S, so that photoelectric conversion efficiency is enhanced.

### Reference Signs List

- 2: : First electrode layer
- 3: : First semiconductor layer
- 4: : Second semiconductor layer
- 5: : Conductive layer
- 6: : Linear portion
- 7, 17: : Connecting portion
- 8: : Second electrode layer
- 9, 29: : Projecting portion
- 20, 120, 220: : Photoelectric conversion cell
- 21, 121, 221: : Photoelectric conversion module

## Claims

1. A photoelectric conversion cell (21), comprising:
first and second electrode layers (2, 8) spaced apart from each other;
a first semiconductor layer (3) of a first conductivity type provided on the first electrode layer;
a second semiconductor layer (4) of a second conductivity type provided on the first semiconductor layer, the second semiconductor layer forming a pn junction with the first semiconductor layer;
a connecting portion (7) for electrically connecting the second semiconductor layer and the second electrode layer; and **characterised by**
a plurality of collector electrodes (6, 9) each with a linear portion (6) and a protecting portion (9), the linear portion extending on the second semiconductor layer from a position above the connecting portion toward an end of the second semiconductor layer, the projecting portion overlapping at least partially the connecting portion in top perspective view, while projecting from at least one of opposite ends of the linear portion in its shorter side direction,
wherein, in two adjacent ones of the plurality of collector electrodes, the projecting portions of the adjacent collector electrodes are spaced apart from each other.

2. The photoelectric conversion cell according to claim 1, wherein
the projecting portion includes a first projecting portion projecting from one of the opposite ends, and a second projecting portion projecting from the other one of the opposite ends, and
the first and second projecting portions are substantially line symmetric with respect to the linear portion.

3. The photoelectric conversion cell according to claim 1, further comprising a conductive layer arranged between the second semiconductor layer and at least one of the plurality of collector electrodes.

4. The photoelectric conversion cell according to claim 3, wherein the conductive layer has an extending portion that extends from the second semiconductor layer toward the second electrode layer, and the conductive layer constitutes the connecting portion by connecting the extending portion to the second electrode layer.

5. The photoelectric conversion cell according to claim 1, wherein the connecting portion has a recess, and the projecting portion of at least one of the plurality of collector electrodes is placed at least partially inside the recess.

6. The photoelectric conversion cell according to claim 1, wherein at least one of the projecting portions of the plurality of collector electrodes makes connection to the second electrode layer to constitute the connecting portion.

7. The photoelectric conversion cell according to claim 1, wherein a front end surface of at least one of the projecting portions of the plurality of collector electrodes is opposite at least either a side surface of the first semiconductor layer or a side surface of the second semiconductor layer while being tilted relative to either side surface.

8. A photoelectric conversion module with a plurality of the photoelectric conversion cells as recited in claim 1, wherein
the plurality of photoelectric conversion cells include first and second photoelectric conversion cells, and
in the first and second photoelectric conversion cells, respective ones of the first and second electrode layers that face in the same direction, and the second electrode layer of the first photoelectric conversion cell and the first electrode layer of the second photoelectric conversion cell are electrically connected.

## Patentansprüche

1. Zelle für photoelektrische Umwandlung (21) mit:
ersten und zweiten Elektrodenschichten (2, 8), die voneinander beabstandet sind,
einer ersten Halbleiterschicht (3) eines ersten Leitfähigkeitstyps, die auf der ersten Elektrodenschicht aufgebracht ist,
einer zweiten Halbleiterschicht (4) eines zweiten Leitfähigkeitstyps, die auf der ersten Halbleiterschicht aufgebracht ist, wobei die zweite Halbleiterschicht einen pn-Übergang mit der ersten Halbleiterschicht bildet,
einem Verbindungsabschnitt (7) zum elektrischen Verbinden der zweiten Halbleiterschicht und der zweiten Elektrodenschicht, und **gekennzeichnet durch**
eine Vielzahl von Kollektorelektroden (6, 9) mit jeweils einem linearen Abschnitt (6) und einem vorstehenden Abschnitt (9), wobei der lineare Abschnitt sich auf der zweiten Halbleiterschicht von einer Position über dem Verbindungsabschnitt zu einem Ende der zweiten Halbleiterschicht erstreckt, wobei der vorstehende Abschnitt wenigstens teilweise den Verbindungsabschnitt überlappt in perspektivischer Draufsicht, während er von wenigstens einem der gegenüberliegenden Enden des linearen Abschnitts in Richtung seiner kürzeren Seite vorsteht,
wobei in zwei benachbarten der Vielzahl an Kollektorelektroden die vorstehenden Abschnitte der benachbarten Kollektorelektroden voneinander beabstandet sind.

2. Zelle für photoelektrische Umwandlung gemäß Anspruch 1, wobei
der vorstehende Abschnitt wenigstens einen ersten vorstehenden Abschnitt, der von einem der gegenüberliegenden Enden vorsteht, und einen zweiten vorstehenden Abschnitt, der von dem anderen der gegenüberliegenden Enden vorsteht, aufweist und
die ersten und zweiten vorstehenden Abschnitte im Wesentlichen liniensymmetrisch in Bezug auf den linearen Abschnitt sind.

3. Zelle für photoelektrische Umwandlung gemäß Anspruch 1, ferner mit einer leitfähigen Schicht, die zwischen der zweiten Halbleiterschicht und wenigstens einer der Vielzahl an Kollektorelektroden angeordnet ist.

4. Zelle für photoelektrische Umwandlung gemäß Anspruch 3, wobei die leitfähige Schicht einen Längsabschnitt aufweist, der sich von der zweiten Halbleiterschicht zu der zweiten Elektrodenschicht erstreckt, und die leitfähige Schicht den Verbindungsabschnitt durch Verbinden dieses Längsabschnitts mit der zweiten Elektrodenschicht bildet.

5. Zelle für photoelektrische Umwandlung gemäß Anspruch 1, wobei der Verbindungsabschnitt einen Ausschnitt aufweist und der vorstehende Abschnitt wenigstens einer der Vielzahl an Kollektorelektroden wenigstens teilweise innerhalb des Ausschnitts angeordnet ist.

6. Zelle für photoelektrische Umwandlung gemäß Anspruch 1, wobei wenigstens einer der vorstehenden Abschnitte der Vielzahl an Kollektorelektroden eine Verbindung mit der zweiten Elektrodenschicht herstellt, um den Verbindungsabschnitt zu bilden.

7. Zelle für photoelektrische Umwandlung gemäß Anspruch 1, wobei eine Oberfläche am vorderen Ende wenigstens einer der vorstehenden Abschnitte der Vielzahl an Kollektorelektroden wenigstens entweder einer Seitenoberfläche der ersten Halbleiterschicht oder einer Seitenoberfläche der zweiten Halbleiterschicht gegenüberliegt, während sie relativ zu einer Seitenoberfläche verdreht ist.

8. Modul für photoelektrische Umwandlung mit einer Vielzahl an Zellen für photoelektrische Umwandlung gemäß Anspruch 1, wobei
die Vielzahl an Zellen für photoelektrische Umwandlung erste und zweite Zellen für photoelektrische Umwandlung aufweist und
in den ersten und zweiten Zellen für photoelektrische Umwandlung die jeweiligen ersten und zweiten Elektrodenschichten in dieselbe Richtung gerichtet sind und die zweite Elektrodenschicht der ersten Zelle für photoelektrische Umwandlung und die erste Elektrodenschicht der zweiten Zelle für photoelektrische Umwandlung elektrisch verbunden sind.

## Revendications

1. Cellule de conversion photoélectrique (21), comprenant :
une première et une deuxième couche d'électrode (2, 8) espacées l'une de l'autre ;
une première couche semi-conductrice (3) d'un premier type de conductivité disposée sur la première couche d'électrode ;
une deuxième couche semi-conductrice (4) d'un deuxième type de conductivité disposée sur la première couche semi-conductrice, la deuxième couche semi-conductrice formant une jonction pn avec la première couche semi-conductrice ;
une partie de connexion (7) pour relier électriquement la deuxième couche semi-conductrice et la deuxième couche d'électrode ; et **caractérisée par**
une pluralité d'électrodes de collecteur (6, 9), chacune avec une partie linéaire (6) et une partie saillante (9), la partie linéaire s'étendant sur la deuxième couche semi-conductrice depuis une position au-dessus de la partie de connexion vers une extrémité de la deuxième couche semi-conductrice, la partie saillante chevauchant au moins partiellement la partie de connexion dans une vue en perspective de dessus, tout en dépassant de l'une au moins d'extrémités opposées de la partie linéaire dans sa direction latérale plus courte,
dans laquelle, dans deux électrodes adjacentes de la pluralité d'électrodes de collecteur, les parties saillantes des électrodes de collecteur adjacentes sont espacées l'une de l'autre.

2. Cellule de conversion photoélectrique selon la revendication 1, dans laquelle
la partie saillante comporte une première partie saillante dépassant de l'une des extrémités opposées, et une deuxième partie saillante dépassant de l'autre des extrémités opposées, et
la première et la deuxième partie saillante sont sensiblement symétriques linéairement par rapport à la partie linéaire.

3. Cellule de conversion photoélectrique selon la revendication 1, comprenant en outre une couche conductrice disposée entre la deuxième couche semi-conductrice et au moins une électrode de la pluralité d'électrodes de collecteur.

4. Cellule de conversion photoélectrique selon la revendication 3, dans laquelle la couche conductrice a une partie d'extension qui s'étend depuis la deuxième couche semi-conductrice vers la deuxième couche d'électrode, et la couche conductrice constitue la partie de connexion en reliant la partie d'extension à la deuxième couche d'électrode.

5. Cellule de conversion photoélectrique selon la revendication 1, dans laquelle la partie de connexion a une encoche, et la partie saillante d'au moins une électrode de la pluralité d'électrodes de collecteur est placée au moins partiellement à l'intérieur de l'encoche.

6. Cellule de conversion photoélectrique selon la revendication 1, dans laquelle l'une au moins des parties saillantes de la pluralité d'électrodes de collecteur établit une connexion avec la deuxième couche d'électrode pour constituer une partie de connexion.

7. Cellule de conversion photoélectrique selon la revendication 1, dans laquelle une surface d'extrémité avant de l'une au moins des parties saillantes de la pluralité d'électrodes de collecteur est opposée au moins à une surface latérale de la première couche semi-conductrice ou à une surface latérale de la deuxième couche semi-conductrice tout en étant inclinée par rapport à l'une ou l'autre surface latérale.

8. Module de conversion photoélectrique avec une pluralité des cellules de conversion photoélectrique selon la revendication 1, dans lequel
la pluralité de cellules de conversion photoélectrique comporte une première et une deuxième cellule de conversion photoélectrique, et
dans la première et la deuxième cellule de conversion photoélectrique, les couches respectives parmi la première et la deuxième couche d'électrode qui sont tournées dans la même direction, et la deuxième couche d'électrode de la première cellule de conversion photoélectrique et la première couche d'électrode de la deuxième cellule de conversion photoélectrique sont reliées électriquement.
